# EUROPÄISCHE PATENTANMELDUNG

(11) **EP 2 551 374 A1**
(43) Veröffentlichungstag der Anmeldung: **30.01.2013**
(21) Anmeldenummer: 12178379.9
(22) Anmeldetag: 27.07.2012
(51) Int. Cl.: C23C 16/513, C23C 16/04

(54) **Verfahren zur Erzeugung einer permeationshemmenden Beschichtung von Kunststoffbehältern und Beschichtungsanlage**

(30) Priorität: 29.07.2011 DE 102011052306
(71) Anmelder: Jokey Plastik Sohland GMBH, 02689 Sohland/Spree (DE)
(72) Erfinder: Blasek, Gerhard, 01257 Dresden (DE); Förster, Rudolf, 02739 Eibau-Walddorf (DE); Mager, Falk, 02689 Sohland / Spree (DE)
(74) Vertreter: Drechsler, Gottfried

(57) **Zusammenfassung**

Beim Verfahren zur Erzeugung einer permeationshemmenden Beschichtung auf Oberflächen eines Kunststoffbehälters zur Minderung der Gaspermeation durch die Behälterwand wird mindestens eine Barriereschicht oder ein Barriereschichtsystem aus zwei oder mehreren Schichten auf einer Oberflächenseite oder auf beiden Oberflächenseiten der Wand des Kunststoffbehälters erzeugt, wobei die Schicht(en) mittels einer oder mehrerer Atmosphärendruck-Plasmajets aus einem gas- oder dampfförmigen oder einem flüssigen Precursor (Vorläufermaterial) unter steuerbaren Prozessbedingungen bei Atmosphärendruck auf die Oberfläche(n) eines Kunststoffbehälters aufgebracht werden. In der Beschichtungsanlage sind eine oder mehrere voneinander abhängige oder unabhängige Atmosphärendruck-Plasmajets angeordnet, die über eine oder mehrere Plasmaaustrittsöffnungen (Düsen) eine oder mehrere Plasmafackel/n ausbilden. Diese Plasmafackel kann linear, flächig oder räumlich angeordnet oder ausgebildet sein und gleichzeitig oder abwechselnd oder nacheinander mit unterschiedlichen Aktivierungs- und Beschichtungsfunktionen wirken.

## Beschreibung

Die Erfindung betrifft ein Verfahren zur Erzeugung einer permeationshemmenden Beschichtung von Kunststoffbehältern und eine Beschichtungsanlage nach den Oberbegriffen der beiden Hauptansprüche.

Kunststoffe müssen für die Verwendung als Packmittel für leicht verderbliche Güter (Lebensmittel, Pharmaka, medizinische und biologische Produkte), für flüchtige Bestandteile enthaltendes Verpackungsgut (kohlensäurehaltige Getränke, Kraftstoffe, Farben, aromatische Produkte) oder auch für sensible elektronische Bauelemente mit entsprechenden Permeationsbarrieren ausgerüstet werden.

So werden - je nach Anwendungsfall - Sauerstoff-, Wasserdampf-, Kohlendioxid- und/oder Kohlenwasserstoffbarrieren benötigt. Dafür - besonders für folienartige Packmittel - gibt es ausgereifte Lösungen durch Beschichten im Hochvakuum (PVD, Physical Vapor Deposition; Aufdampfen, Aufsputtern) mit permeationshemmenden Werkstoffen (Aluminium, SiO₂, Al₂O₃ u.a.), siehe hierzu H. C.. Langowski in G. Blasek, G. Bräuer: Vakuum Plasma Technologien, Leuze Verlag, 2010).

Besonders der wachsende Bedarf an Kunststoffbehältern für verderbliche Lebensmittel, aber auch z. B. für lösungsmittelhaltige Produkte, die schwere und kostspielige metallische oder Glasverpackungen ablösen, macht auch die Ausrüstung dreidimensionaler Packmittel wie Dosen, Eimer, Schalen und Tanks immer interessanter.

Bekannt sind technische Lösungen (z. B. Kunststoffrohre für Warmwasserversorgung) mit mehrlagigem Mantelaufbau und einer innen liegenden Aluminiumfolie oder einer sogenannten EVOH-Schicht, was für massenhaft benötigte Behälter aus Kostengründen eher ungeeignet ist. Für kleinvolumige Getränkeflaschen wird die innere Mantelfläche mit einem PCVD-Verfahren (Plasma Chemical Vapor Depositon) zur Minderung der Kohlendioxidpermeation mit einer etwa 20 nm dicken SiOx-Schicht versehen (DE 3 632 748 A1, siehe auch H. Grünwald in der oben zitierten Publikation). Dafür muss allerdings die Flasche auf Niederdruck (1 bis 100 Pa)evakuiert werden, ein SiOx-liefernder dampfförmiger Vorläufermaterial (Precursor) zugegeben und kurzzeitig eine MikrowellenGasentladung gezündet werden, die das Behältervolumen ausfüllt. Der Precursor wird fragmentiert, und eine (Plasmapolymer-) Schicht scheidet sich dabei ab.

Die oben genannten Hochvakuumverfahren sind für großvolumige (z. B. 1000 cm³ und deutlich größere) Behälter und - für den Fall einer Innenbeschichtung - auch für Behälter mit einem großen Verhältnis von Tiefe zu Höhe (Aspektverhältnis) wegen hoher Anlagenkosten für hoch produktive Inline-Anlagen für niedrigpreisige Massenprodukte allerdings zu kostspielig ( sie erfordern Vakuumkammern, Schleusen, Ventile, Hochvakuumerzeuger, Bewegung- und Transportvorrichtungen u. a.) oder sogar völlig ungeeignet.

Mittels PCVD mit einem das Gefäßvolumen ausfüllendem Niederdruckplasma können große Gefäße außen beschichtet werden, benötigen aber produktive und damit ebenfalls teure Inline-Anlagen mit einer ähnlich aufwändigen Vakuumtechnik. Die sind aber auch erforderlich, wenn vorzugsweise der Innenraum großvolumiger, in der Regel dünnwandiger Behälter (Wanddicke deutlich unter 1 mm) beschichtet werden sollen. Die PCVD-Beschichtung mit einer produktiven Inline-Anlage beschränkt sich vorteilhaft also auf kleinvolumige Behälter mit einer großen Einfüllöffnung (kleines Aspektverhältnis, flache Schalen, Schüsseln u. ä.). Das wesentliche Hindernis für hochproduktive Hochvakuum- oder Niederdruck-Inline-Anlagen liegt also in den erheblichen Vakuumanlagenkosten, die eine kostengünstige Produktion von massenhaft benötigten Kunststoffbehältern verhindern. Hinzu kommt ihre schlechte Integrierbarkeit in den gesamten Fertigungsprozess (Spritzgießprozess) der Kunststoffbehälter.

Bekannt sind weiterhin eine Vielzahl von verschiedenen Publikationen und Patentenschriften im Fachgebiet zur Erzeugung von Barriereschichten. Beispielsweise seien hier die Veröffentlichung B. S. E. Babayan u. a., Plasma Sources Sci. Technol. 10 (2001) S. 573-578; U. Lommatzsch, J. Ihde; Plasma Sources Sci. Technol. 6 (2009) 10, S. 642-648; und die Patentschriften US 6,194,036 A1, WO 0 132 949 A1, WO 20 080 082 A1 und die DE 6 0 101 747 A1.

Daraus folgt der Bedarf und die Notwendigkeit eines Verfahrens und der dazugehörigen Anlagentechnik für eine kostengünstige, hochproduktive permeationshemmende Beschichtung von großvolumigen Kunststoffbehältern mit einer großen Einfüllöffnung und einem großen Aspektverhältnis (1 oder mehr).

Der Erfindung liegt daher die Aufgabe zu Grunde, ein neuartiges, für die Massenproduktion geeignetes, flexibles und kostengünstiges Verfahren zur Erzeugung einer permeationshemmenden Beschichtung für insbesondere großvolumige Kunststoffbehälter zu entwickeln und eine zugehörige konstruktiv einfache und sich in einen Spritzgießprozess leicht integrierbare Beschichtungsanlage zu schaffen, welche bei Atmosphärendruck arbeitet und die erheblichen Nachteile der Hochvakuum- und Niederdruckverfahren vermeidet.

Die Aufgabe wird erfindungsgemäß durch die Merkmale des ersten bzw. achten Patentanspruches gelöst. Weitere zweckmäßige Ausgestaltungen der Erfindung sind Gegenstand der Unteransprüche. Beim erfindungsgemäßen Verfahren zur Erzeugung einer permeationshemmenden Beschichtung auf Oberflächen eines Kunststoffbehälters zur Minderung der Gaspermeation durch die Behälterwand wird mindestens eine Barriereschicht oder ein Barriereschichtsystem aus zwei oder mehreren Schichten auf einer Oberflächenseite oder auf beiden Oberflächenseiten der Wand des Kunststoffbehälters erzeugt, wobei die Schicht(en) mittels einer oder mehrerer Atmosphärendruck-Plasmaquellen aus einem gas- oder dampfförmigen oder einem flüssigen Precursor (Vorläufermaterial) unter steuerbaren Prozessbedingungen bei Atmosphärendruck auf die Oberfläche(n) eines Kunststoffbehälters aufgebracht werden.

Als besonders vorteilhaft erweist sich, wenn eine oder mehrere diskrete Plasmaquellen in Form von Atmosphärendruck-Plasmajets für die Oberflächenaktivierung und -beschichtung zur Erzeugung der Barriereschicht oder des Barriereschichtsystems benutzt werden, wobei ein auf die Oberfläche (d. h. die Behälterwand) des Kunststoffbehälters gerichteter Plasmastrom erzeugt wird, der aus einer Düse (Plasmaaustrittsöffnung) (Düse) austritt und als gerichtetes Plasmabündel (Plasmafackel, Plasmajet) ausgebildet ist und auf das zu behandelnde Kunststoffmaterial trifft.

Im Folgenden wird unter Atmosphärendruck-Plasmaquelle immer ein Atmosphärendruck-Plasmajet verstanden. Vorteilhaft ist es, wenn diese Atmosphärendruck-Plasmaquelle im erfindungsgemäßen Verfahren zur Herstellung einer permeationshemmenden Beschichtung mit Edelgasen, Sauerstoff, Stickstoff oder deren Gemischen, so auch mit Luft, betrieben werden, wobei das Plasma bei Atmosphärendruck mit einer Gleich-, Niederfrequenz-, Hochfrequenz- oder Mikrowellengasentladung erzeugt und der dem Plasma zugeführte Precursor im Plasma modifiziert bzw. fragmentiert und als eine haftfeste Barriereschicht auf der Oberfläche des Kunststoffbehälters abgeschieden wird.

Da beim Verfahren mit einem geeignet gewählten, dem Plasmabündel (Plasmafackel, Plasmajet) zugeführten Precursor definierte Barriereschicht(en) einer bestimmten stofflichen Zusammensetzung abgeschieden werden, kann im Ergebnis die Gaspermeation durch die Behälterwand von Kunststoffbehältern so verringern oder voreingestellt werden, dass die Qualität des Behälterinhaltes über deutlich längere Zeiträume als bisher ermöglicht bzw. schädigende chemische Umwandlungen im Kunststoffbehälter verhindert und dass nahezu alle Formen von großvolumigen Kunststoffbehältern nicht nur außen, sondern bei großen Einfüllöffnungen und Bedarf auch innen beschichten werden können.

Ein besonders großer Vorteil gegenüber den bisher eingesetzten Verfahren ist es, dass die benutzte Atmosphärendruck-Plasmaquelle in Form eines Atmosphärendruck-Plasmajets mit atmosphärischer Luft (zum Beispiel trockener, mit einem Kompressor erzeugter Druckluft) arbeiten kann und damit das Verfahren zur Erzeugung einer oxydischen permeationshemmenden Beschichtung im Sinne der Aufgabenstellung zusätzlich besonders kostengünstig gestaltet werden kann.

Das erfindungsgemäße Verfahren zur Erzeugung einer permeationshemmenden Beschichtung kann auch so ausgeführt werden, dass die Oberfläche des Kunststoffbehälters vor der ersten Beschichtung in Abhängigkeit vom Kunststoffmaterial mittels einer zusatzfreien Atmosphärendruck-Plasmaquelle zunächst aktiviert oder zuerst aus einem dem Plasma zugeführten Vorläufermaterial (Precursor) eine haftvermittelnde und/oder glättende und/oder die Benetzbarkeit modifizierende Hilfsschicht abgeschieden wird, wobei das Vorläufermaterial für die Hilfsschicht eine plasmapolymerisierbare Kohlenwasserstoff- oder eine organometallische Verbindung ist und die Schichtdicken dann wahlweise zwischen 10 und bei Glättungsschichten bis einigen Mikrometern betragen können. Das bewirkt neben einer verbesserten Haftung der nachfolgend abgeschiedenen Barriereschicht auch eine erhebliche Verbesserung der Bedruck-, Bekleb- und Lackierbarkeit der Oberflächen des Kunststoffbehälters, wie sie herkömmlicherweise bislang nur mit viel Aufwand zum Beispiel durch Beflammen erreicht werden konnte. Diese Lösung wird nunmehr durch das neuartige Verfahren ersetzt.

Dieses neuartige Verfahren kann vorteilhaft in einem dem Spritzgießprozess unmittelbar nachfolgenden Prozess oder auch erst nach Zwischenlagerung der Behälter realisiert werden. Dabei kann die Aktivierung bzw. Beschichtung entweder mit einem einzelnen oder einem Array einzelner Plasmajets erfolgen. Der Beschichtungsprozess kann einstufig oder mehrstufig geführt werden. Als mehrstufiger Beschichtungsprozess kann mit linear oder auch auf einem Karussell angeordneten mehreren Beschichtungsstufen (z. B. dicke Schichten oder Schichtsysteme) gearbeitet werden.

Das erfindungsgemäße Verfahren zur Erzeugung einer permeationshemmenden Beschichtung kann auch so ausgeführt werden, dass die Oberfläche des Kunststoffbehälters vor der ersten Beschichtung in Abhängigkeit vom Kunststoffmaterial mittels einer zusatzfreien Atmosphärendruck-Plasmaquelle zunächst aktiviert oder zuerst aus einem dem Plasma zugeführten Vorläufermaterial (Precursor) eine haftvermittelnde und/oder glättende und/oder die Benetzbarkeit modifizierende Hilfsschicht abgeschieden wird, wobei das Vorläufermaterial für die Hilfsschicht eine plasmapolymerisierbare Kohlenwasserstoff- oder eine organometallische Verbindung ist und die Schichtdicken dann wahlweise zwischen 10 bis 1000 nm betragen können. Das bewirkt eine erhebliche Verbesserung der Bedruck-, Bekleb- und Lackierbarkeit der Oberflächen des Kunststoffbehälters, wie sie herkömmlicherweise nur durch Beflammen erreicht wird und wodurch dieses ersetzt werden kann.

Mit dem erfindungsgemäßen Verfahren ist es erstmals möglich, mit einer als Atmosphärendruck-Plasmajet ausgebildeten Atmosphärendruck-Plasmaquelle, d. h. mit einem vakuumfreien Verfahren bei Atmosphärendruck haftfeste oxydische Permeationsbarrieren auf großvolumigen Kunststoffbehältern kostengünstig und hoch produktiv abzuscheiden und damit die Eignung des insbesondere sehr kostengünstigen Verfahrens herzustellen wobei dieses Verfahren sich auch vorteilhaft in den Spritzgießprozess integrieren lässt.

Als Precursoren für plasmapolymere oder auch elementare Schichten eignen sich Kohlenwasserstoffe und metallorganische (darunter siliziumorganische) gas- bzw. dampfförmige, aber auch flüssige und feste Materialien. In einer speziellen Ausbildung des Verfahrens zur Erzeugung einer permeationshemmenden Beschichtung kann die Barriereschicht oxydisch ausgeführt sein. Eine besonders kostengünstige und verfahrenstechnisch einfache Beschichtung mittels Atmophärendruck-Plasmajets ergibt sich, wenn man als Precursor, wie bei der Niederdruckplasma PCVD siliziumorganische Materialien, z. B. HMDSO, TEOS und TMDSO für die Erzeugung von SiOx-Schichten eingesetzt (x < 2), die - wie XPS-Messungen zeigen -je nach Prozessführung auch noch mehr oder weniger Kohlenstoff enthalten. Die Haftfestigkeit auf dem Kunststoff (insbesondere auf Olefinen wie z. B. Polypropylen) wird durch eine Plasmavorbehandlung (z. B. im Argonplasma des Atmosphärendurch-Plasmajets ohne Precursorzufuhr) erreicht. Partikelarme Schichten ergeben sich bei Precursorinjektion in den Relaxationsbereich des Plasmas. Es ist von Vorteil, dass als Plasmagas trockene Luft und als Precursortreibgas Argon eingesetzt werden kann. Derartige Schichten sind bisher lediglich als Korrosionsschutzschichten auf Metallen (wie Aluminium und Kupfer) bekannt, aber nicht als Permeationsbarrieren auf Kunststoffen. Die Schichtdicke kann hier zwischen 10 und 100 nm, vorzugsweise zwischen 30 und 50 nm liegen, wobei S_{q}-Rauigkeit des Kunststoffsubstrats zweckmäßigerweise 150 nm nicht übersteigen sollte.

Bei Bedarf können die Barriereschichten auch durch Atmosphärendruck-PCVD mit Hilfe der Atmosphärendruck-Plasmaquelle aus anderen Werkstoffen erzeugt werden, so aus Titanoxid aus titanorganischen Precursoren und sauerstoffhaltigem Plasmagas (z. B. Luft) oder Siliziumnitrid aus siliziumorganischen Precursoren mit Stickstoff als Plasmagas und/oder Ammoniak als Reaktivgaszusatz oder aus (wasserstoffhaltigen) Kohlenstoffschichten mit einem inerten Treibgas und Kohlenwasserstoffen als Precursor, wobei die Schichtdicken zwischen 10 und 100 nm ausgebildet sind.

Mit unterschiedlichen Schichtwerkstoffen ist es möglich, die Barriereschicht(en) sowohl an den Kunststoff des Kunststoffbehälters als auch an das zu schützende Verpackungsgut des Kunststoffbehälters so anzupassen, dass zum Beispiel eine erhebliche längere Lagerung als bisher möglich wird.

Besonders effektiv und ökonomisch sinnvoll ist es, wenn die Schichtdicken beim erfindungsgemäßen Verfahren zur Erzeugung einer permeationshemmenden Beschichtung der Barriereschicht in einem Bereich zwischen 30 und 50 nm liegen.

Mit der Abscheidung von Barriereschichten wird auch ein Austritt von anderen Kunststoffbestandteilen (additiven) in das Verpackungsgut vermindert oder verhindert.

Generell ist es auch möglich, dass mit dem Verfahren zur Erzeugung einer permeationshemmenden Beschichtung die Barriereschicht als ein Mehrschichtsystem ausgebildet ist. Dabei sind zwischen zwei oder mehreren oxydischen Schichten eine oder mehrere Plasmapolymerschichten übereinander aufgebracht, welche aus Kohlenwasserstoffverbindungen bestehen. Durch diese Kombination lässt sich Gaspermeabilität weiter vermindern, und an das Verpackungsgut entsprechend anpassen.

Für bestimmte Anwendungsfälle (z. B. lösungsmittelhaltiges Verpackungsgut wie Lacke, reaktive Substanzen, wie organische Chlorverbindungen oder konzentrierte Säuren oder Laugen) kann es vorteilhaft sein, Precursoren zuführen, mit denen eine Wechselwirkung des Verpackungsguts mit dem Kunststoff des Behälters verhindert wird. Hierfür werden Precursoren für glas-keramische Schichten, also silizium- oder alumiumorganische Verbindungen, oder Fluorkohlenwassserstoff-Plasmapolymerschichten aus Fluorkohlenstoffen oder Fluorkohlenwasserstoffen eingesetzt. Auch die Kratz- und Abriebfestigkeit sowie die wasser- bzw. schmutzabweisende Wirkung kann so erreicht bzw. erhöht werden. Insbesondere können solche Barriereschichten auch mehrschichtig sein (Schichtsysteme) sein, und es können dazwischen haftungssteigernde Schichten integriert angeordnet oder hydrophobe Schichten erzeugt werden.

Bei der erfindungsmäßigen Beschichtungsanlage zur Erzeugung einer permeationshemmenden Beschichtung auf Oberflächen von Kunststoffbehältern zur Minderung der Gaspermeation durch die Behälterwand mittels einer Barriereschicht sind eine oder auch mehrere voneinander abhängige oder unabhängige Atmosphärendruck-Plasmaquelle(n) angeordnet und ausgebildet, wobei deren konstruktive Besonderheiten und Anordnung der einzelnen Teile der Beschichtungsanlage an die Beschichtung des Außenmantels, des Bodens und von Deckeln und der Innen- und Außenbeschichtung jeweils angepasst sein können. Diese Atmosphärendruck-Plasmaquelle(n), bilden Plasmaströme in der Art von einer gerichteten Plasmafackel oder gerichteter Plasmafackeln aus, welche über eine oder mehrere Plasmaaustrittsöffnungen (Düsen) austreten. Diese Plasmaaustrittsöffnungen (Düsen) können linear, flächig, oder räumlich angeordnet und ausgebildet sein und wahlweise gleichzeitig oder abwechselnd oder nacheinander mit unterschiedlichen Aktivierungs- und Beschichtungsfunktionen wirken. Die Kunststoffbehälter können an diesen Plasmaaustrittssöffnungen (Düsen) schrittweise getaktet oder stetig vorbei geführt und können dabei zusätzlich definiert gesteuert, starr oder rotierend in zwei oder drei Achsen linear oder kreisartig entlang transportiert werden.

Bei der neuartigen Beschichtungsanlage zur Erzeugung einer permeationshemmenden Beschichtung kann die Form der Plasmaaustrittsdüsenöffnung einer oder mehrerer Atmosphärendruck- Plasmaquelle/n der Form und/oder der Größe des zu beschichtenden Kunststoffbehälters angepasst ausgebildet sein.

Es ist auch möglich, dass mindestens eine Plasmaaustrittsöffnung (Düse) der Atmosphärendruck-Plasmaquelle der Beschichtungsanlage zur Erzeugung einer permeationshemmenden Beschichtung dreidimensional bewegbar und steuerbar angeordnet ist oder das der Kunststoffbehälter so um eine speziell ausgebildete und geformte Plasmaaustrittsöffnung (Düse) gedreht, geschwenkt oder bewegt werden kann, dass die äußere, die innere oder beide Oberflächen des Kunststoffbehälters teilweise oder vollständig beschichtet werden können.

Von erheblichem Vorteil ist es bei der Beschichtungsanlage zur Erzeugung einer permeationshemmenden Beschichtung, wenn mindestens eine Plasmaaustrittsdöffnung (Düse )der Atmosphärendruck- Plasmaquelle/n der Oberflächenform des Kunststoffbehälters nachführbar angeordnet ist und/oder dass der Kunststoffbehälter so bewegt, gedreht oder geschwenkt und positionierbar ist, dass der Abstand zwischen der Oberfläche des Kunststoffbehälters und der Plasmaaustrittsöffnung (Düsenöffnung) während des Beschichtens einstellbar ausgebildet ist. Dadurch kann eine besonders gleichmäßige Schichtdicke und eine sehr gute Oberflächenqualität der Barriereschicht(en) ausgebildet werden.

Von besonders vorteilhafter Wirkung des neuartigen erfindungsgemäßen Verfahrens ist es, dass bei leicht verderblichen, chemisch und biologisch leicht veränderbaren Gütern, wie beispielsweise Lebensmitteln, Pharmaka oder empfindlichen medizinisch-biologischen Substanzen oder Stoffgemischen oder auch bei Farben oder anderen chemischen Produkten sowohl außen als auch innen die Kunststoffbehälter mit einer an das eingebrachte Verpackungsgut speziell angepassten Sauerstoffbarriere und/oder Wasserdampfbarriere und/oder Strahlenschutzbarriere ausgebildet werden können.

Das neuartige Verfahren hat den Vorteil, dass es unter Atmosphärendruck arbeitet und dadurch erheblich weniger Anlagenkosten gegenüber einer Vakuumbeschichtungsanlage entstehen. Zudem kann der Beschichtungsprozess in relativ kurzen Zeiteinheiten erfolgen, so dass die bei Spritzgießmaschinen kurzen Taktzeiten für die Herstellung eines Kunststoffbehälters nahezu auch bei der Aufbringung der Barriereschicht(en) erreicht werden können.

Die Anwendung des erfindungsgemäßen Verfahrens und der Beschichtungsanlage erfolgt in erster Linie für Kunststoffbehälter, wie zum Beispiel Kunststoffdosen, Kunststoffeimer, Kunststoffschalen, einschließlich zugehöriger Kunststoffdeckel.

Besonders positiv wirkt sich aus, dass permeationshemmend ausgerüstete Kunststoffbehälter aus preis- und fertigungsgünstigen Polypropylen mit SiOx-Schichten mit Dicken vorzugsweise zwischen 30 und 50 nm aus einem siliziumorganischen Precursor (vorzugsweiseTEOS) mit einen bei Atmosphärendruckverfahren und unter Verwendung von Luft als Plasmagas produktiv und kostengünstig so beschichtet werden können, dass eine Permeationsminderung auf 1 % bei fertigungsüblichen Wanddicken der Propylenbehälter von 0,8 mm möglich ist.

Durch das erfindungsgemäße Verfahren und die neuartige Beschichtungsanlage ist es erstmals möglich, insbesondere bei großvolumigen Kunststoffbehältern, z. B. mit einem Aspektverhältnis von größer als 1 und bei relativ großen Einfüllöffnungen die gewünschten Gebraucheigenschaften bei Atmosphärendruck und sogar unter Nutzung von atmosphärischer Luft bei Bereitstellung mittels eines normalen Kompressors zu erreichen.

Die Erfindung soll nachstehend an Hand der Figuren 1 bis 5 näher erläutert werden.
- Fig. 1 zeigt: schematisch die Integration der neuartigen Beschichtungsanlage 3 in einen allgemein übliche Herstellungsanlage von Kunststoffbehältern 12
- Fig. 2 zeigt: schematisch eine übliche bisherige Herstellungsanlage ohne Beschichtungsanlage 3
- Fig. 3 zeigt: eine nachgerüstete neuartige Beschichtungsanlage 3 an eine bisherig übliche Herstellungsanlage von Kunststoffbehältern 12
- Fig. 4 zeigt: schematisch den Verfahrensablauf in der neuartigen Beschichtungsanlage 3 für die Außenbeschichtung des Kunststoffbehälters 12
- Fig. 5 zeigt: schematisch den Verfahrensablauf in der neuartigen Beschichtungsanlage 3 für die Innenbeschichtung des Kunststoffbehälters 12

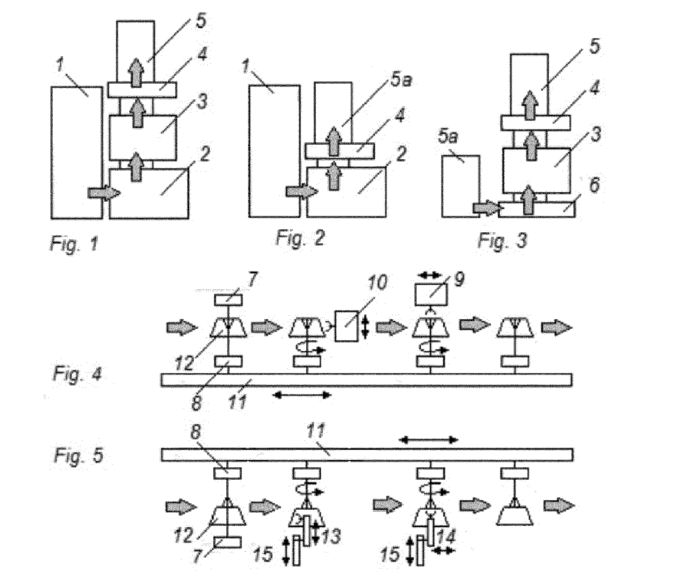

Als Kunststoffbehälter oder zu beschichtendes Erzeugnis 12, welche mit dem neuartigen Verfahren mit einer Barriereschicht oder einem Barriereschichtsystem wahlweise nur innen, außen oder innen und außen beschichtet werden können, sind hier bevorzugt Eimer mit oder ohne Henkel, Dosen, Schalen und gegebenenfalls zugehörige Deckel zu verstehen. Figur 1 zeigt eine Herstellungsanlage für Kunststoffbehälter 12. Die Kunststoffbehälter 12, wie zum Beispiel rotationssymmetrische Kunststoffeimer, werden in der Spritzgießanlage 1 hergestellt und gelangen über eine Entnahmeeinheit 2 in die Beschichtungseinheit 3. Die beschichteten Kunststoffbehälter 12 werden in dem Fall, wo es sich um Kunststoffbehälter 12 mit Bügeln handelt, in einer Bügel- und Stapeleinheit 4 mit Bügeln versehen und gleichzeitig gestapelt. Anschließend gelangen diese in einen Pufferspeicher 5.

In Figur 2 ist eine übliche bisherige Herstellungsanlage ohne Beschichtungsanlage 3 abgebildet. Der Pufferspeicher 5a dient dann als Zwischenspeicher für unbeschichtete Kunststoffbehälter 12.

Dann wird gemäß Figur 3 verfahren, wo gezeigt ist, dass die Kunststoffbehälter 12 aus dem Pufferspeicher 5a mittels einer Entstapeleinheit 6 entnommen und mit einer Übergabeeinheit 7 dann der Beschichtungseinheit 3 zugeführt werden. Dann erfolgt die Beschichtung in der Beschichtungseinheit 3, die Entnahme mit der Entstapeleinheit 4 und dem Speichern im Speicher 5.

In Figur 4 ist ein bevorzugter Verfahrensablauf in der neuartigen Beschichtungsanlage 3 dargestellt. Die bereitgestellten Kunststoffbehälter 12 werden mittels einer Übergabeeinheit 7 einem Drehmodul 8 zugeführt, der die Kunststoffbehälter 12 auf einer linearen Transporteinheit 11 positioniert. Das Drehmodul 8 kann bei Bedarf in der linearen Transporteinheit 11 linear verfahren werden, wobei der zu beschichtende Kunststoffbehälter 12 entsprechend dem eigentlichen Beschichtungsprozess zugeführt wird. Für die mögliche Außenbeschichtung der äußeren Oberfläche des Kunststoffbehälters 12 wird der Kunsstoffbehälter 12 innen, wie aus Figur 4 ersichtlich, direkt am Boden gehalten und lösbar befestigt. Dann erfolgt eine Zuführung zur Position Außenbeschichtung Mantel 10. Die Außenbeschichtung Mantel 10 kann entsprechend der Kunststoffbehälterform und -größe verfahren, nachgeführt und bewegt werden. Anschließend erfolgt ein lineares Verfahren an die Position Außenbeschichtung Boden 9. Hier ist die Bodenbeschichtungsanlage ebenfalls der Form und Größe des Kunststoffbehälters 12 angepasst ausgebildet und bei Bedarf bewegbar, schwenkbar oder nachführbar ausgebildet. Bevorzug wird der Kunststoffbehälter 12 während der Beschichtung in Rotation um seine Achse versetzt. Es ist aber auch möglich z. B. bei nicht rotationssymmetrischen Kunststoffbehältern 12, wie z. B. bei recheckig ausgebildeten Eimern den Abstand zwischen der Plasmaaustrittsdüse und der Oberfläche des Kunststoffbehälters 12 jeweils konstant zu halten, wobei entweder das Drehmodul 8, die Beschichtungseinheit oder beide gleichzeitig zueinander bewegt und geführt werden können. Danach erfolgt, falls erforderlich, das Trocknen und/oder Aushärten, bevor der Kunststoffbehälter 12 von der Bügel- und/oder Stapeleinheit 4 vom Drehmodul 8 entnommen wird und in den Speicher 5 gegeben wird.

Die Innenbeschichtung des Kunststoffbehälters 12, falls erforderlich, erfolgt analog, wie in Figur 5 schematisch abgebildet. Der Kunststoffbehälter 12 wird dann außen an seinem Boden gefasst und lösbar befestigt. Auch hier erfolgt während des Beschichtungsprozesses bevorzugt eine Rotation um die Achse des Kunststoffbehälters 12. Die einzelnen Positionen zur Innenbeschichtung des Mantels 13 und zur Innerbeschichtung des Bodens 14 werden mittels einer gesteuerten Bewegung der Plasmaaustrittsöffnung (Düse) mittels einer linearen Hubeinheit angefahren. Nach der Beschichtung erfolgt, wenn erforderlich, eine Trocknung oder Aushärtung in einer gesonderten Position bzw. eine direkte Entnahme und Übergabe in den Speicher 5.

Generell ist es auch möglich, anstelle einer linear aufgebauten Beschichtungseinheit mit nacheinander angeordneten Verfahrensstufen auch eine andere Anordnung wie zum Beispiel in der Art eines Schrittschalttisches mit paralleler Anordnung der Verfahrensstufen zu realisieren.

Die neuartige Beschichtungsanlage zur Erzeugung einer permeationshemmenden Beschichtung kann auch mehrstufig ausgebildet und aufgebaut sein. Dabei können bei Bedarf die einzelnen Verfahrensschritte nacheinander seriell oder gleichzeitig parallel an mehreren Positionen ausgeführt werden. Mit solch einer Beschichtungsanlage kann dann bei Atmosphärendruck die Beschichtung problemlos an unterschiedliche gewünschte Eigenschaften der Beschichtung angepasst werden, indem zum Beispiel die Plasmajets mit unterschiedliche chemische Verbindungen beschickt werden und sich nur der jeweils oder die jeweils gerade benötigten Plasmajets in eingriff gebracht werden. Hiermit können des Weiteren unterschiedliche mehrlagige Barriereschichten aus gleichen oder unterschiedlichen Verbindungen hergestellt werden. Darüber hinaus ist es mit der Beschichtungsanlage und dem erfindungsgemäßen Verfahren möglich innerhalb der üblichen Taktzeiten einer handelsüblichen Kunststoffbehälter - Spritzgießanlage die gewünschte Barriereschicht oder eine Barriereschichtsystem äußerst kostengünstig aufzubringen

### Bezugszeichenliste

- 1: Spritzgießmaschine
- 2: Entnahmeeinheit
- 3: Beschichtungseinheit
- 4: Bügel- und/oder Stapeleinheit
- 5: Speicher oder 5a Pufferspeicher
- 6: Entstapeleinheit
- 7: Übergabeeinheit
- 8: Drehmodul
- 9: Außenbeschichtung Boden
- 10: Außenbeschichtung Mantel
- 11: Lineare Transporteinheit
- 12: Kunststoffbehälter bzw. zu beschichtendes Erzeugnis
- 13: Innenbeschichtung Mantel mit linearer Hubeinheit
- 14: Innenbeschichtung Boden mit linearer Hubeinheit

## Patentansprüche

1. Verfahren zur Erzeugung einer permeationshemmenden Beschichtung auf Oberflächen eines Kunststoffbehälters zur Minderung der Gaspermeation durch die Behälterwand mittels einer Barriereschicht,
**dadurch gekennzeichnet,**
**dass** mindestens eine Barriereschicht oder ein Barriereschichtsystem aus zwei oder mehreren Schichten auf einer Oberflächenseite oder auf beiden Oberflächenseiten der Behälterwand des Kunststoffbehälters erzeugt werden,
wobei die Schicht(en) mittels einer oder mehrerer Atmosphärendruck-Plasmaquelle aus einem gas- oder dampfförmigen oder einem flüssigen Precursor (Vorläufermaterial) unter steuerbaren Prozessbedingungen bei Atmosphärendruck auf die Oberfläche(n) eines Kunststoffbehälters aufgebracht werden.

2. Verfahren zur Erzeugung einer permeationshemmenden Beschichtung nach Anspruch 1, **dadurch gekennzeichnet,**
**dass** die Atmosphärendruck-Plasmaquelle mit einem Plasmagas, bestehend aus Luft oder Sauerstoff oder Stickstoff oder Kohlendioxiod oder Edelgas oder deren Mischungen betrieben wird, wobei ein auf die Oberfläche des Kunststoffbehälters gerichteter Plasmastrom erzeugt wird, welcher als gerichtete Plasmafackel (Atmosphärendruck-Plasmajet) ausgebildet ist, wobei bei Atmosphärendruck ein über ein Trägergas in das Plasma einer Gleich-, Niederfrequenz-, Hochfrequenz- oder Mikrowellengasentladung eingeleiteter Precursor (Vorläufermaterial) im Plasma modifiziert und als eine haftfeste Barriereschicht auf der Oberfläche des Kunststoffbehälters abgeschieden wird.

3. Verfahren zur Erzeugung einer permeationshemmenden Beschichtung nach Anspruch 1 oder 2,
**dadurch gekennzeichnet,**
**dass** die Oberfläche des Kunststoffbehälters vor der ersten Beschichtung in Abhängigkeit vom Kunststoffmaterial mittels einer zusatzfreien Atmosphärendruck-Plasmaquelle (Atmosphärendruck-Plasmajet) aktiviert oder aus einem dem Plasma zugeführten Precursor (Vorläufermaterial) eine haftvermittelnde und/oder glättende und/oder die Benetzbarkeit modifizierende Hilfsschicht abgeschieden wird, wobei das Vorläufermaterial für die Hilfsschicht eine plasmapolymerisierbare Kohlenwasserstoff- oder eine metallorganische Verbindung ist und die Schichtdicken 10 bis 1000 nm betragen.

4. Verfahren zur Erzeugung einer permeationshemmenden Beschichtung nach Anspruch 1 bis 3,
**dadurch gekennzeichnet,**
a) **dass** die Barriereschicht oxidisch ausgeführt ist,
wobei der Precursor (Vorläufermaterial) zur Erzeugung der Barriereschicht aus einer plasmapolymerisierbaren metallorganischen Verbindung besteht, d. h.
- für Siliziumoxid aus einer siliziumorganischen Verbindung,
- für Aluminiumoxid aus einer aluminiumorganischen Verbindung und
- für Titanoxid aus einer titanorganischen Verbindung,
mit einem sauerstoffhaltigen Plasmagas (also auch Luft) gearbeitet wird und die Schichtdicke der Barriereschicht zwischen 10 und 100 nm ausgebildet ist,
b) oder dass die Barriereschicht als eine Siliziumnitridschicht ausgeführt ist,
wobei der Precursor zur Erzeugung der Barriereschicht aus einer siliziumorganischen Verbindung besteht,
mit Stickstoff oder einem Edelgas mit Stickstoffzusatz oder Ammoniakzusatz als Plasmagas gearbeitet wird
und die Schichtdicke der Barriereschicht zwischen 10 und 100 nm ausgebildet ist,
c) oder dass die Barriereschicht als eine wasserstoffhaltige Kohlenstoffschicht ausgeführt ist,
wobei der Precursor aus eineiner plasmapolymerisierbaren Kohlenwassserstoffverbindung besteht,
mit einem Inertgas (Edelgas) als Plasmagas gearbeitet wird
und die Schichtdicke der Barriereschicht zwischen 10 und 100 nm ausgebildet ist,
d) oder das die Barriereschicht als eine Fluorkohlenstoffschicht oder Fluorkohlenwasserstoffschicht ausgeführt ist,
wobei der Precursor aus einer Fluorkohlenstoffverbindung oder Fluorkohlenwasserstoffverbindung besteht,
mit einem Edelgas als Plasmagas (Treibgas) gearbeitet wird
und die Schichtdicke der Barriereschicht zwischen 10 und 1000 nm ausgebildet ist.

5. Verfahren zur Erzeugung einer permeationshemmenden Beschichtung nach Anspruch 4, **dadurch gekennzeichnet,**
**dass** die Schichtdicken der Barriereschicht zwischen 20 und 50 nm betragen.

6. Verfahren zur Erzeugung einer permeationshemmenden Beschichtung nach Anspruch 1, **dadurch gekennzeichnet,**
**dass** die Barriereschicht als ein Mehrschichtsystem ausgebildet ist,
wobei zwischen zwei oder mehreren oxydischen Schichten eine oder mehrere Plasmapolymerschichten aufgebracht sind, welche aus Kohlenwasserstoffverbindungen bestehen.

7. Verfahren zur Erzeugung einer permeationshemmenden Beschichtung nach Anspruch 3, **dadurch gekennzeichnet,**
**dass** der Atmosphärendruck-Plasmaquelle (Atmosphärendruck-Plasmajet) als Precursoren (Vorläufermaterialien) Verbindungen wie plasmapolymerisierbare metallorganische Verbindungen, Kohlenwasserstoffverbindungen bzw. Fluorkohlenstoffverbindungen und Fluorkohlenwasserstoffverbindungen zugeführt werden
und auf der inneren Oberfläche des Kunststoffbehälters chemisch bzw. gegen Lösungsmittel beständige oxydische, lackartige, organische, bzw. fluorkohlenstoffpolymere Barriereschichten abgeschieden werden,
wobei die Schichtdicke der Barriereschicht zwischen 10 nm und mehreren Mikrometern ausgebildet ist.

8. Beschichtungsanlage zur Erzeugung einer permeationshemmenden Beschichtung auf Oberflächen von Kunststoffbehältern zur Minderung der Gaspermeation durch die Behälterwand mittels einer Barriereschicht,
**dadurch gekennzeichnet,**
**dass** eine oder mehrere voneinander abhängige oder unabhängige Atmosphärendruck-Plasmaquellen (Atmosphärendruck-Plasmjets), die über eine oder mehrere Plasmaaustrittsöffnungen (Düsen) eine oder mehrere Plasmafackel/n ausbilden,
welche linear, flächig oder räumlich angeordnet oder ausgebildet sind und gleichzeitig oder abwechselnd oder nacheinander mit unterschiedlichen Aktivierungs- und Beschichtungsfunktionen wirken,
wobei die Kunststoffbehälter an diesen schrittweise getaktet oder stetig vorbei geführt, definiert gesteuert, starr oder rotierend in zwei oder drei Achsen entlang transportiert werden.

9. Beschichtungsanlage zur Erzeugung einer permeationshemmenden Beschichtung nach Anspruch 8,
**dadurch gekennzeichnet,**
**dass** die Form der Plasmaaustrittsöffnung (Düse) einer oder mehrerer Atmosphärendruck-Plasmaquelle/n (Atmosphärendruck-Plasmajet/s) der Form und/oder der Größe des zu beschichtenden Kunststoffbehälters angepasst ausgebildet sind.

10. Beschichtungsanlage zur Erzeugung einer permeationshemmenden Beschichtung nach Anspruch 8,
**dadurch gekennzeichnet,**
**dass** die Plasmaaustrittsöffnung (Düse) mindestens einer Atmosphärendruck-Plasmaquelle (Atmosphärendruck-Plasmajet) dreidimensional bewegbar und steuerbar angeordnet ist, oder dass der Kunststoffbehälter so um eine speziell ausgebildete und geformte Plasmaaustrittsöffnung (Düse) gedreht, geschwenkt oder bewegt werden kann,
**dass** die äußere, die innere oder beide Oberflächen des Kunststoffbehälters teilweise oder vollständig beschichtet werden können.

11. Beschichtungsanlage zur Erzeugung einer permeationshemmenden Beschichtung nach Anspruch 8,
**dadurch gekennzeichnet,**
**dass** die Plasmaaustrittsöffnung (Düse) mindestens einer Atmosphärendruck- Plasmaquelle (Atmosphärendruck-Plasmajet) der Oberflächenform des Kunststoffbehälters nachführbar angeordnet sind
und/oder dass der Kunststoffbehälter so bewegt, gedreht oder geschwenkt und positionierbar ist,
**dass** der Abstand zwischen der Oberfläche des Kunststoffbehälters und der Plasmaaustrittsöffnung (Düse) während des Beschichtens einstellbar ausgebildet ist.

12. Beschichtungsanlage zur Erzeugung einer permeationshemmenden Beschichtung nach Anspruch 8,
**dadurch gekennzeichnet,**
**dass** die Beschichtungsanlage mehrstufig ausgebildet ist und die Verfahrensschritte nacheinander seriell oder gleichzeitig parallel an mehreren Positionen ausgeführt werden.
